Europäisches Patentamt

European Patent Office

Office européen des brevets

(19)

(11) Publication number: **0 010 138**
**B1**

(12) **EUROPEAN PATENT SPECIFICATION**

(45) Date of publication of patent specification: **19.01.83**

(21) Application number: **79103102.4**

(22) Date of filing: **23.08.79**

(51) Int. Cl.³: **C 23 F 7/06, C 23 F 1/00, C 23 C 15/00, H 01 L 21/88**

(54) A method of treating aluminium microcircuits.

(30) Priority: **25.09.78 US 945164**

(43) Date of publication of application:
**30.04.80 Bulletin 80/9**

(45) Publication of the grant of the patent:
**19.01.83 Bulletin 83/3**

(84) Designated Contracting States:
**DE FR GB IT**

(56) References cited:
**DE - A - 2 708 720**
**DE - B - 2 539 193**
**US - A - 3 394 066**
**US - A - 3 496 030**
**US - A - 3 660 173**
**US - A - 3 986 897**
**US - A - 3 994 793**
**US - A - 4 030 967**
**US - A - 4 057 460**
**US - A - 4 073 669**

(73) Proprietor: **International Business Machines Corporation**
**Armonk, N.Y. 10504 (US)**

(72) Inventor: **Eldridge, Jerome Michael**
**20568 Lomita Avenue**
**Saratoga California 95171 (US)**
Inventor: **Lee, Wen-Yaung**
**465 1/2 Curie Drive**
**San Jose California 95123 (US)**
Inventor: **Schwartz, Geraldine Cogin**
**19 Woodward Road**
**Poughkeepsie New York 12603 (US)**

(74) Representative: **Chaudhry, Mohammad Saeed**
**IBM United Kingdom Patent Operations Hursley Park**
**Winchester Hants, S021 2JN (GB)**

A method of treating aluminium microcircuits

The invention relates to a method of treating aluminium microcircuits which have been prepared by reactive-ion etching. The microcircuit is stabilized against open circuits and short circuits by the method according to the invention.

The manufacture of microcircuit devices by means of reactive-ion etching is now well established in the art. Two fairly recent patents which illustrate such processes are U.S. patents 4,026,742 and 4,057,460.

While reactive-ion etching has many advantages in the formation of microcircuits, it does have a disadvantage in the case of circuits based upon aluminium as the conductor. Aluminium which has been subjected to reactive-ion etching tends, upon the passage of time, to disintegrate. This disintegration causes open circuits and short circuits and is obviously a severe disadvantage.

The prior art teaches the treatment of aluminium containing alloys in an oxidizing atmosphere. U.S. patent 3,496,030 discloses the treatment of an aluminium alloy in an atmosphere of helium containing steam. U.S. patent 3,660,173 discloses the treatment of ferro alloys containing some aluminium in an oxidizing atmosphere at a temperature of 1000°C to 1400°C. U.S. Patent 3,394,066 discloses a method of forming an aluminium oxide film on an aluminium surface, in which the aluminium surface is first exposed to an oxygen-containing atmosphere to form a priming coat of aluminium oxide on said surface and thereafter said priming coating is exposed to an oxygen plasma. During exposure to said oxygen plasma, an electrical potential is impressed across said priming coat by contacting said aluminium film with an electrode and supplying to said electrode electric current to make the aluminium surface positive with respect to said plasma.

DE—A 2 708 720 discloses the exposure of an aluminium microcircuit to oxygen plasma after the circuit has been formed on a substrate by reactive-ion etching.

According to the present invention, there is provided a method of treating an aluminium microcircuit on a substrate which is formed by reactive-ion etching, the method comprising heating the microcircuit in the presence of an oxygen containing atmosphere at a temperature from 200°C to 450°C.

The best results have been obtained when the microcircuit is treated by heating it at 350°C in an atmosphere of oxygen for at least 1/2 hour. Results are less favourable when the temperature is above 450°C.

When aluminium is referred to in the present application, it is to be understood that the term was intended to include alloys which are chiefly aluminium. Many such alloys are used in the manufacture of microcircuits. For example, an alloy of aluminium with 4% copper is a frequently used one. Another example is an alloy of aluminium with copper and silicon. The process of the present invention is fully applicable to such alloys.

A film of aluminium alloy with 4% copper approximately 1 mm thick was prepared by vacuum deposition of an oxidized silicon wafer substrate. The film was reactive-ion etched in a plasma of carbon tetrachloride and argon using a T-system diode reactor at 27MHz frequency with a silicon diode cathode. The input power density was 0.33 watts/cm². The total pressure was $10\mu$ and the active gas pressure was $2\mu$. Photo resist masks were used to pattern the 1 $\mu$m thick aluminium layer into a microcircuit.

The aluminium microcircuit prepared above was stabilized by heating for 1/2 hour at a temperature of 350°C under one atmospheric pressure (1,01325 bar) of oxygen. Samples which have been heat treated according to this process were found to resist deterioration for much longer periods than untreated samples, and to be free of open circuits and short circuits.

**Claims**

1. A method of treating an aluminium microcircuit on a substrate which is formed by reactive-ion etching, the method comprising heating the microcircuit in the presence of an oxygen containing atmosphere at a temperature from 200°C to 450°C.

2. A method as claimed in claim 1, in which the heating is conducted at 350°C for at least one-half hour under one atmosphere pressure (1.01325 bar) of oxygen gas.

3. A method as claimed in claim 1 or 2, in which the aluminium is present in the form of an alloy consisting of 96% aluminium and 4% copper.

4. A method as claimed in claim 1 or 2, in which the aluminium is present in the form of an alloy including aluminium, copper and silicon.

**Patentansprüche**

1. Verfahren zum Behandeln einer Aluminium-Mikroschaltung auf einem Substrat, welche mittels reaktiven Ionenätzens hergestellt worden ist, dadurch gekennzeichnet, daß bei dem Verfahren die Mikroschaltung in der Gegenwart einer Sauerstoff enthaltenden Atmosphäre bei einer Temperatur zwischen 200 und 450°C erhitzt wird.

2. Verfahren nach Anspruch 1, bei dem das Erhitzen bei 350°C mindestens eine halbe Stunde lang bei einem Sauerstoffdruck von einer Atmosphäre (1,01325 bar) durchgeführt wird.

3. Verfahren nach Anspruch 1 oder 2, bei dem das Aluminium in der Form einer Legierung vorliegt, welche aus 96% Aluminium und 4% Kupfer besteht.

4. Verfahren nach Anspruch 1 oder 2 bei dem das Aluminium in der Form einer Aluminium, Kupfer und Silicium enthaltenden Legierung vorliegt.

**Revendications**

1. Procédé de traitement d'un microcircuit en aluminium sur un substrat, qui a été préparé par un décapage à ions réactifs, le procédé comprenant le chauffage du microcircuit dans une atmosphère contenant de l'oxygène, à une température comprise entre 200 et 450°C.

2. Procédé selon la revendication 1 dans lequel le chauffage est effectué à 350°C pendant au moins une demi-heure sous une pression de 1 atmosphère (1,01325 bar) de gaz d'oxygène.

3. Procédé selon la revendication 1 ou 2 dans lequel l'aluminium est présent sous la forme d'un alliage composé de 96% d'aluminium et de 4% de cuivre.

4. Procédé selon la revendication 1 ou 2 dans lequel l'aluminium est présent sous la forme d'un alliage comprenant de l'aluminium, du cuivre et du silicium.